# EUROPEAN PATENT SPECIFICATION

(11) **EP 1 215 792 B1**
(45) Date of publication and mention of the grant of the patent: **01.02.2012**
(21) Application number: 00204455.0
(22) Date of filing: 12.12.2000
(51) Int. Cl.: H02H 3/04

(54) **An improved control device and method thereof**
Verbesserte Steuervorrichtung und entsprechendes Verfahren
Dispositif de commande amélioré et méthode correspondante

(43) Date of publication of application: 19.06.2002
(73) Proprietor: ABB Technology AG, 8050 Zürich (CH)
(72) Inventor: Gemme, Carlo, 16166 Genova Quinto (IT); Borlotti, Roberto, 24060 Bagnatica (BG) (IT); Corbetta, Giuliano, 20110 Milano (IT)
(74) Representative: Giavarini, Francesco

(56) References cited:
- DE-A- 19 529 013
- US-A- 4 360 853

## Description

The present invention relates to an improved control device and method thereof. More particularly, the present invention relates to an improved control device for controlling the opening/closing operation of a switchgear, such as a circuit breaker, a disconnector, a recloser or the like. The control device according to the present invention is particularly useful for the use in medium-voltage power distribution networks (i.e. generally for voltage values higher than 1 KV).

As it is known, closing/opening operations of a switchgear are generally controlled by a control device, which generally comprises an actuation chain for actuating (i.e. coupling/decoupling) the electric contacts of the switchgear and a control unit. The control unit receives opening/closing commands (for example by a protection device or by an operator) and, based on these commands, it sends controls signals to the actuation chain that provides for operating the electric contact of the switchgear, so as to bring it in the desired operating status.

In the prior art, actuation chains were generally of mechanical type. In this kind of actuation chains, mechanical arrangements, such as springs and leverages, were generally adopted for actuating the electric contacts of the switchgear.

Recently, in order to improve performances, control devices have been provided with electromagnetic actuation chains. An electromagnetic actuation chain generally comprises an electromagnetic actuator, operatively connected to the electric contacts of the switchgear. The electromagnetic actuator is generally supplied with electric power by means of a power circuit, which draws the electric energy from capacitor banks, able to store a certain amount of electric energy. Finally, a power charger provides electric power to the capacitor banks in order to maintain a suitable level of stored electric energy.

Once the control unit receives an opening/closing signal, it commands the power circuit to provide electric power to the electromagnetic actuator. Meanwhile, the power charger provides electric power to the capacitor banks in order to restore a suitable level of stored electric energy.

Control devices, adopting an electromagnetic actuation chain, have represented a remarkable improvement in the state of the art, particularly in terms of reliability, costs and performances.

Nevertheless, some drawbacks are still present.

A main drawback is represented by the fact that, often, it is quite difficult to evaluate the residual life of the pieces of the electromagnetic chain. This difficulty is due to the fact that electromagnetic/electromechanical arrangements are adopted. Thus, diagnostics requires often stopping operations and, very often, adopting complicate algorithms for calculating the residual life of a piece of the electromagnetic actuation chain. In practice, it is very difficult to achieve quickly a satisfactory knowledge about the capability of a certain piece of the electromagnetic actuation chain to perform an operation when needed. Thus, very often, maintenance interventions have to be performed "a posteriori", i.e. after the arising of a failure. In this case, relatively long operation stops may be required for identifying the location and the consistency of the failure. This, obviously, means increased operation costs of the switchgear. These drawbacks become also more critical, if the operation of the control device is remotely controlled. In fact, in this case, a maintenance intervention can be quite expensive. Obviously, one could provide for the substitution of various pieces of the electromagnetic actuation chain, according a regular maintenance schedule. The practice has shown that this approach could be quite expensive due to the fact that, statistically, pieces with still an extended residual life may be very often substituted. Further, this approach does not preserve from sudden failures, just before or during operations.

A control device for controlling the opening/closing of a switchgear comprising an actuation chain and testing means for executing real-time tests of the operative efficiency of said actuation chain is known from US4360853.

The main aim of the present invention is to provide a control device for controlling the opening/closing operation of a switchgear, which is provided with an electromagnetic actuation chain and which allows checking, at any time, the operative efficiency of the whole electromagnetic actuation chain.

Within this aim, another object of the present invention is to provide a control device, which allows checking, at any time, the operative efficiency of each single piece of the electromagnetic actuation chain.

Another object of the present invention is to provide a control device, which allows performing diagnostics of the electromagnetic actuation chain, substantially on-line, i.e. without stopping operations of the switchgear.

Another object of the present invention is to provide a control device, which allows performing diagnostics of the electromagnetic actuation chain, also from a remote location.

Not the least object of the present invention is to provide a control device, which is to realize and at competitive costs.

The above objects are achieved by means of a control device and a method for executing real time tests as defined in the independent claims.

Further characteristics and advantages of the invention will become more apparent from the detailed description of preferred embodiments of the control device according to the present invention, illustrated only by way of non-limitative example in the accompanying drawings, wherein:
Figure 1 is a block diagram, which schematically illustrates an embodiment of the control device, according to the invention; and
Figure 2 is a plot, which schematically illustrates a method for executing real time tests of the efficiency of the control device, according to the present invention; and
Figure 3 is a plot, which schematically illustrates another a method for executing real time tests of the efficiency of the control device, according to the present invention.

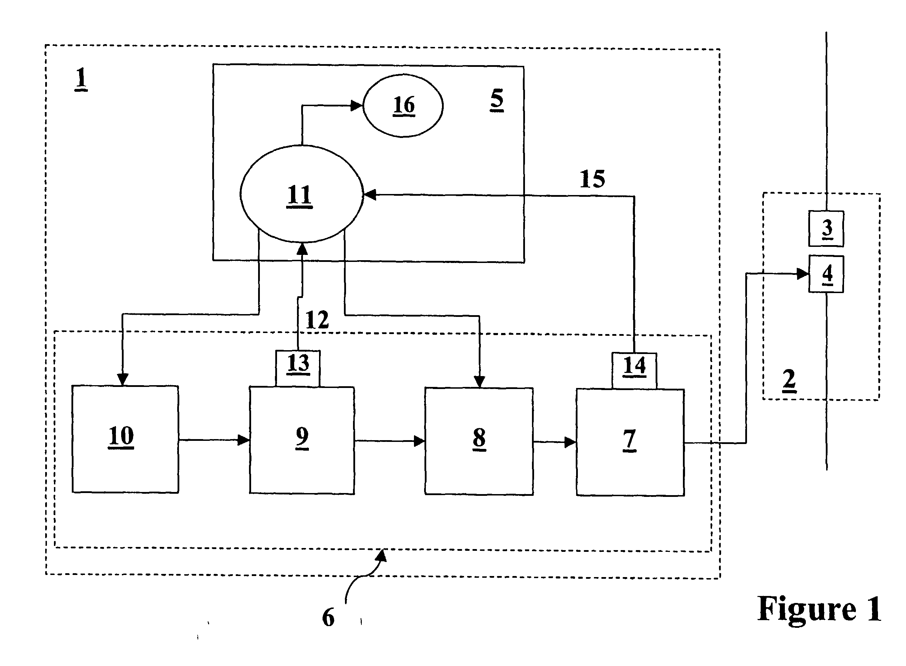

Referring to figure 1, the control device 1, according to the present invention, is used for controlling the opening/closing operation of a switchgear 2. The switchgear 2 comprises at least a fixed contact and a movable contact (schematically represented by blocks 3 and 4) that are coupled/decoupled respectively during a closing/opening operation of the switchgear 2. The control device 1 comprises a control unit 5 and an electromagnetic actuation chain 6 for actuating the movable contact 4. The electromagnetic actuation chain 6 is controlled by the control unit 5 and comprises at least an electromagnetic actuator 7, operatively connected to the movable contact 4 by means of a kinematic chain (not shown). Preferably, the electromagnetic actuation chain 6 comprises power electronic means 8, which are electrically connected and which supply electric power to the electromagnetic actuator 7. Further, energy storage means 9, electrically connected to the power electronic means 8 may be included. The energy storage means 9, which may comprise a plurality of capacitor banks, which store a certain amount of electric enerdy that is supplied to the electromagnetic actuator 7, when needed. A suitable level of stored electric energy is kept substantially constant by power charger means 10, electrically connected to the energy storage means 9, which are able to provide electric power to the energy storage means 9. Power charger means may include power converters connected to a power source.

In a preferred embodiment of the control device, according to the present invention, the electromagnetic actuator 7 comprises an excitation coil (not shown) for generating a magnetic flux and a movable plunger (not shown), operatively connected to the movable contact 4 by means of a kinematic chain. In this manner, the movable plunger is operated by a magnetic force, which is generated by at least a portion of the magnetic flux, enchaned with the movable plunger. The excitation coil may comprise two opposite windings. A predefined current is forced in a winding when a closing operation has to be performed or in the opposite winding when an opening operation is needed. Alternatively, the excitation coil may comprise a single winding, into which two different currents are forced, depending on the needed opening/closing operation. In any case, a magnetic field, whose direction depends of the kind of operation that is required, is generated. Thus, the movable plunger is subjected to a force, which may have substantially two different directions and, therefore, it can move the plunger, so as to couple/decouple the electric contacts 3 and 4 of the switchgear, according to the needs.

The peculiarity of the control device 1, according to the present invention, consists of the fact that the control unit 5 comprises electronic testing means for executing real-time tests of the operative efficiency of the electromagnetic actuation chain 6. With the term "real-time tests" it means the fact that these tests may employ periods of time that are relatively short (i.e. some tens of milliseconds or less). Further, the results of these real-time tests can be used for the determining the continuation of the operations of the electromagnetic actuation chain. Therefore, due their "real-time" nature, these real-time tests may be performed at any time, i.e. before or after or even during operations of the electromagnetic chain. Moreover, they can be easily performed routinely (e.g. every hour) or upon a specific command (local or remote) by the user.

According to the present invention, the electronic testing means comprise a computerized module 11. The computerized module 11 is capable to execute real time tests of the operative efficiency of the electromagnetic actuation chain 6 by means of operating the electromagnetic actuator 7 for at least a period of time and monitoring the amount of electric energy which is needed for operating the electromagnetic actuator 7. In practice, thanks to the computerized module 11, electric power is provided, for at least a certain period of time, to the electromagnetic actuator 7 and the amount of electric energy, which has been adsorbed by the electromagnetic actuator 7 during this period of time, is checked.

Particularly, the computerized module 11 may command the power electronic means 8 to supply electric power to the electromagnetic actuator 7, for at least a first period of time T1. During T1, the electromagnetic actuator 7 may be supplied, according to a first mode, which does not force the electromagnetic actuator 7 to change its operating state (i.e. not to actuate the movable contact 4).

According to a further preferred embodiment, the computerised module 11 may command the power electronic means 8 to supply electric power to the electromagnetic actuator 7, also for a second period of time T2, subsequent to T1. As it will be described better in the following, the extension of T2 depends, preferably, on the position of the movable contact 4, with respect to the fixed contact 3. In this case, the electromagnetic actuator 7 is preferably supplied, so as to start changing its operating state (i.e. to start actuating the movable contact 4). Subsequently, the power charger means 10 may supply electric power to the energy storage means 9, for at least a third period of time T3, subsequent to T1 and/or T2.

The electronic testing means of the control device 1, according to the present invention, comprise advantageously first sensor means 13. The first sensor means 13 provide the computerised module 11 with signals 12 indicative of the level of electric energy stored in the energy storage means 9, during periods T1 and/or T2 and/or T3. The first sensor means 13 may comprise, for example, voltage sensors, which sense the voltage across the capacitor banks, included in the energy storage means 9. Further, the electronic testing means may comprise advantageously second sensor means 14, which provide the computerized module 11 with signals 15 indicative of the position of the movable contact 4, during periods T1 and/or T2. The second sensor means 14 may comprise position sensors located in correspondence of the movable contact 4 or, as illustrated in figure 1, position sensors located in correspondence of the electromagnetic actuator 7 (for example sensing the position of the movable plunger).

Finally, the electronic testing means may comprise alarm means 16 that are activated by the computerized module 11, in case the real-time tests indicate the presence of a possible failure. In practice, if a possible failure is detected, the operation of the switchgear may be suspended and the user may be advised promptly (either locally or remotely).

As mentioned above, the control device 1, according to the present invention, allows performing real time tests of the operative efficiency of the actuation chain 6.

These real-time tests comprise at least a first phase in which the electromagnetic actuator 7 is operated for at least a period of time and a second phase, in which the amount of electric energy, needed for operating the electromagnetic actuator 7, is monitored. These phases may also be repeated several times in order to improve the diagnostics accuracy.

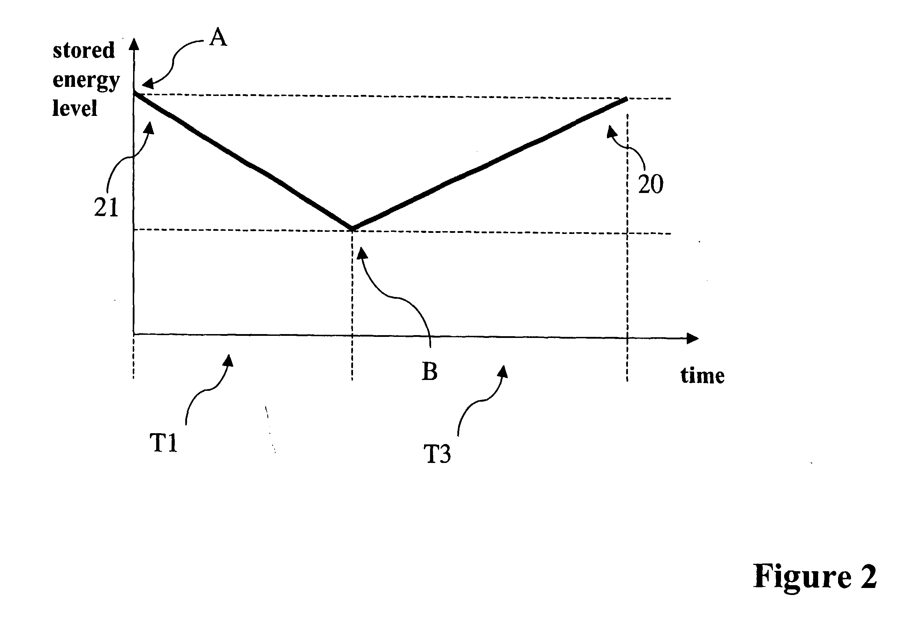

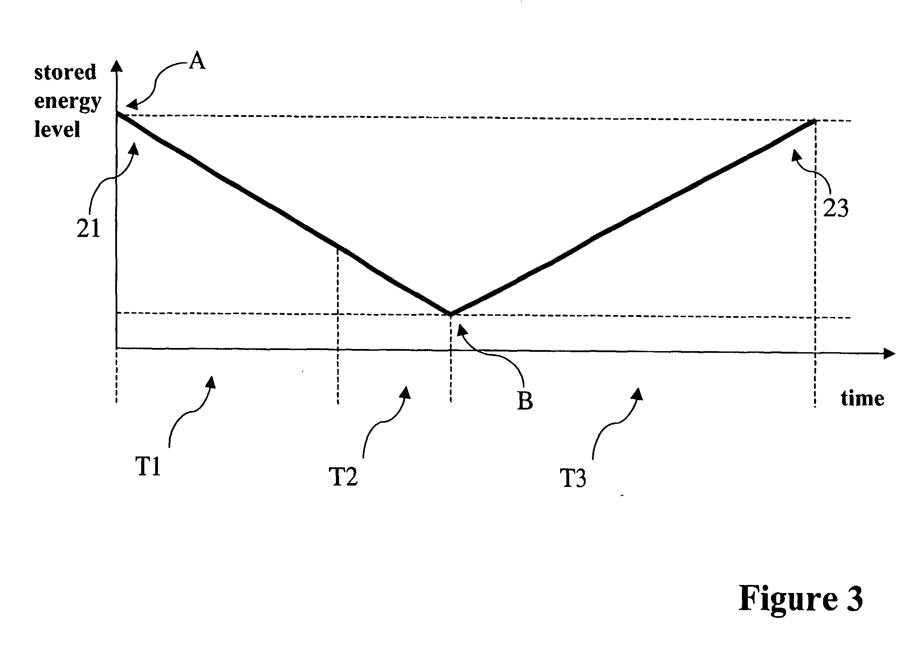

With reference also to figures 2 and 3, a preferred embodiment of this method, for executing real-time tests of the operative efficiency of the actuation chain 6, is described hereinafter.

According to this embodiment, a starting step, in which the computerised module 11 commands the power electronic means 8 to supply electric power to the electromagnetic actuator 7, is executed. Then, a first measuring step, which employs the period T1, may be executed. In this measuring step, the computerised module 11 receives from the first sensors means 13 signals 14, indicative of the level of electric energy stored in the energy storage means 9 during T1.

Alternatively, the first measuring step may employ periods T1 and T2. In this case, the computerised module 11 receives from the first sensor means 13 signals 14, indicative 14 of the level of electric energy stored in the energy storage means 9 during T1 and T2, and from the second sensor means 13 signals 15, indicative 14 of the position of the movable contact 4. The extension of the period T2 is decided based on the position of the movable contact 4.

Then, after periods T1 and/or T2, a stopping step, in which the computerised module 11 commands the power electronic means 8 to stop to supply electric power to the electromagnetic actuator 7, may be executed.

Then a second measuring step (period T3), in which the computerised module 11 receives from the first sensors means 13 signals 14, indicative of the level of stored electric energy stored during T3, is executed.

At this point, a comparison step may be executed. In the comparison step, the computerised module 11 compares the data related to the level of electric energy stored in the energy storage means 9, during periods of time T1 and/or T2 and T3, with predefined reference data stored in the control unit 5.

Finally, it may be executed an alarm step, in which the computerised module activates the alarm means 16, if the comparison step indicates the presence of a failure. Otherwise, the operation of the control device 1 may continue normally, according to the needs.

The advantages of the control device 1, according to the present invention are remarkable.

During T1 electric power is injected into the electromagnetic actuator 7. The electromagnetic actuator, before actuating the movable contact 4, must be energized, so as to create a suitable magnetic field. During this period of time the electromagnetic actuator is electrically equivalent to a passive circuit (particularly to a RL circuit), which dissipates electric power. The consumption of electric energy is monitored by means of the first sensor means 13 and can be used as an indicator of the efficiency of the electromagnetic actuation chain 6, due to the fact that the consumption in this period of time is due to constant effects.

Particularly, indications related to the efficiency of the energy storage means 9, the power electronic means 8 and the electromagnetic actuator 7 may be obtained. The consumption curve 21 is monitored and compared with reference data that may be stored during installation of the control device 1. Differences between the consumption curve 21 and the stored reference data may indicate the presence of a failure. During T3 electric power is injected by the charger means 10 into the electric energy storage means 9. The data monitored in T3 allows defining a charging curve 20, which is capable to indicate the presence of a failure in the power charger means 10. If a failure is present, the charging curve 20 is different from the reference one, stored during installation. Further, the evaluation of the consumption curve 21 and the charging curve 20 and comparing them with the reference data, failures of electric energy storage means 9 may be detected with a remarkable level of accuracy. In this case, errors due to the compensation of opposite effects can be avoided. Periods T1 and T3 may be predefined or simply may be considered as the periods of time, which are needed for going from a initial predefined level of stored electric energy (reference "A") to another predefined level of stored electric energy ("B") and vice-versa.

As mentioned above, if electric power is provided to the electromagnetic actuator 7 only during the period T1, the electromagnetic is preferably not forced to change its operating state. In this manner, only the efficiency of the elements 7, 8, 9 and 10 of the electromagnetic actuation chain 6 may be checked.

In an alternative embodiment of the described method, the electric power may be provided to the electromagnetic actuator 7, during periods T1 and T2. In this case, the electromagnetic actuator 7 is preferably forced to change its operating state. In practice, during period T2, the movable contact 4 is moved. The entity of the movement, which determines the extension of the period T2, is detected by the second sensor means 14. In practice, the movable contact 4 may be moved till no perturbations of the operating status of the switchgear arise. In this case, the consumption curve 22 of figure 3 may be indicative also of the presence of failures in the kinematic chain (e.g. due to mechanical wear) or in the coupling between the electrical contacts 3 and 4 (e.g. due to abnormal contact forces). Associating the consumption curve 22 with the charging curve 23, indications related to failures on every single piece of the electromagnetic actuation chain 6 may be obtained.

The control device 1, according to the present invention, allows achieving the intended aims and objects.

Particularly, it allows checking at any time the operative efficiency of the whole electromagnetic actuation chain, with a high level of accuracy.

Further, the electromagnetic actuation chain is not checked only as a whole but the operative efficiency of each different single piece of the electromagnetic actuation chain may be easily tested. In this manner, a failure may be promptly located. The control device, according to the present invention allows also avoiding the need of stopping operations of the switchgear, for performing diagnostics of the electromagnetic actuation chain. Moreover, the diagnostics may be easily performed both locally and remotely.

Finally, the control device, according to the present invention, has proven to require, in practice, relatively low cost efforts for its realization.

## Claims

1. A control device (1) for controlling the opening/closing operation of a switchgear, said switchgear comprising at least a movable contact (4) and a fixed contact (3), which are coupled/decoupled respectively during a closing/opening operation of said switchgear,
said control device comprising:
- a control unit (5); and
- an electromagnetic actuation chain (6) for actuating said movable contact, said actuation chain being controlled by said control unit and comprising at least an electromagnetic actuator (7), operatively connected to said movable contact by means of a kinematic chain, said control unit comprising electronic testing means for executing real-time tests of the operative efficiency of said actuation chain;
**characterised in that** said electronic testing means comprise a computerised module (11) which is capable to execute real time tests of the operative efficiency of said actuation chain by operating said electromagnetic actuator for at least a period of time (T1,T2,T3) and by monitoring the amount of electric energy needed for operating said electromagnetic actuator for said period of time.

2. A control device, according to claim 1, **characterised in that** said actuation chain further comprises:
- power electronic means (8), electrically connected to said electromagnetic actuator, for supplying electric power to said electromagnetic actuator; and
- energy storage means (9), electrically connected to said power electronic means, for storing an amount of electric energy; and
- power charger means (10), electrically connected to said energy storage means, for providing electric power to said energy storage means.

3. A control device, according to claim 2, **characterised in that**, during the execution of said real time tests, said computerised module commands said power electronic means to supply electric power to said electromagnetic actuator, for at least a first period of time (T1).

4. A control device, according to claim 3, **characterised in that**, during the execution of said real time tests, said computerised module commands said power electronic means to supply electric power to said electromagnetic actuator, also for a second period of time (T2), subsequent to said first period of time, the extension of said second period of time depending on the position of said movable contact.

5. A control device, according to claims 3 or 4, **characterised in that**, during the execution of said real time tests, said power charger means supply electric power to said energy storage means for at least a third period of time (T3) subsequent to said first and/or second periods of time.

6. A control device, according to claim 3, **characterised in that**, during said first period of time, said electromagnetic actuator maintains unchanged its operating state.

7. A control device, according to claim 4, **characterised in that**, during said first and second periods of time, said electromagnetic actuator starts changing its operating state.

8. A control device, according to claims from 2 to 5, **characterised in that** said electronic testing means comprise first sensor means (13), which provide said computerised module with signals indicative of the level of electric energy stored in said energy storage means during said first and/or second and/or third periods of time.

9. A control device, according to claims from 2 to 5, **characterised in that** said electronic testing means comprise second sensor means (14), which provide said computerised module with signals indicative of the position of said movable contact during said first and/or second periods of time.

10. A control device, according to one or more of previous claims, **characterised in that** said electronic testing means comprise alarm means (16) that are activated by said computerised module in case said real time tests of the efficiency of said actuation chain indicate the presence of a failure.

11. A control device, according to one or more of previous claims, **characterised in that** said electromagnetic actuator (7) comprises:
- at least an excitation coil for generating a magnetic flux; and
- at least a movable plunger, operatively connected to said movable contact by means of a kinematic chain, said movable plunger being operated by a magnetic force, which is generated by at least a portion of said magnetic flux, enchaned with said movable plunger.

12. A method for executing real time tests of the operative efficiency of the electromagnetic actuation chain of a control device, according to one or more of the previous claims, **characterised in that** it comprises at least the following phases:
- a first phase, in which said electromagnetic actuator is operated for at least a period of time; and
- a second phase, in which the amount of electric energy needed for operating said electromagnetic actuator, is monitored.

13. A method, according to claim 12, **characterised in that** it comprises one or more of the following steps:
- a starting step, in which said computerised module commands power electronic means to supply electric power to said electromagnetic actuator; and
- a first measuring step, in which:
- said computerised module receives from first sensors means signals indicative of the level of electric energy stored in energy storage means during said first period of time; or
- said computerised module receives, from said first sensors means signals indicative of the level of electric energy stored in said energy storage means and from second sensor means signals indicative of the position of said movable contact, during said first period of time and a second period of time; and
- a stopping step, in which said computerised module commands said power electronic means to stop to supply electric power to said electromagnetic actuator; and
- a second measuring step, in which said computerised module receives from said first sensors means signals indicative of the level of electric energy stored in said energy storage means during a third period of time, subsequent to said first period of time; and
- a comparison step, in which said computerised module compares the trends of the level of electric energy stored in said energy storage means during said first and third periods of time with predefined reference data/information stored in said control unit.

14. A method, according to claim 13, **characterised in that** it comprises the following step:
- an alarm step, in which said computerised module activates alarm means, if said comparison step indicates the presence of a failure.

## Patentansprüche

1. Steuervorrichtung (1) zum Steuern des Öffiiungs-/Schließungsbetriebs einer Schaltanlage, wobei die Schaltanlage zumindest einen beweglichen Kontakt (4) und einen festen Kontakt (3) aufweist, die während eines Schließungs-/Öffnungsbetriebs der Schaltanlage miteinander verbunden / voneinander getrennt werden, wobei die Steuervorrichtung aufweist:
- eine Steuereinheit (5); und
- eine elektromagnetische Betätigungskette (6) zum Betätigungen des beweglichen Kontakts, wobei die Betätigungskette von der Steuereinheit gesteuert wird und zumindest ein elektromagnetisches Stellglied (7) aufweist, das wirkmäßig mittels einer kinematischen Kette mit dem beweglichen Kontakt verbunden ist, wobei die Steuereinheit eine elektronische Testeinrichtung aufweist, um Echtzeittests des Wirkungsgrads der Betätigungskette durchzuführen;
- **dadurch gekennzeichnet, dass** die elektronische Testeinrichtung ein computergestütztes Modul (11) aufweist, das in der Lage ist, durch Betreiben des elektromagnetischen Stellglieds über zumindest einen Zeitraum (T1, T2, T3) und durch Überwachen der Menge an elektrischer Energie, die nötig ist, um das elektromagnetische Stellglied über den Zeitraum zu betreiben, Echtzeittests des Wirkungsgrads der Betätigungskette durchzuführen.

2. Steuervorrichtung nach Anspruch 1, **dadurch gekennzeichnet, dass** die Betätigungskette ferner aufweist:
- eine elektronische Leistungseinrichtung (8), die elektrisch mit dem elektromagnetischen Stellglied verbunden ist, um dem elektromagnetischen Stellglied elektrische Leistung zuzuführen; und
- eine Energiespeichereinrichtung (9), die elektrisch mit der elektronischen Leistungseinrichtung verbunden ist, um eine Menge elektrischer Energie zu speichern; und
- eine Ladeeinrichtung (10), die elektrisch mit der Energiespeichereinrichtung verbunden ist, um die Energiespeichereinrichtung mit elektrischer Leistung zu versorgen.

3. Steuervorrichtung nach Anspruch 2, **dadurch gekennzeichnet, dass** während der Durchführung der Echtzeittests das computergestützte Modul der elektronischen Leistungseinrichtung befiehlt, dem elektromagnetischen Stellglied über zumindest einen ersten Zeitraum (T1) Leistung zuzuführen.

4. Steuervorrichtung nach Anspruch 3, **dadurch gekennzeichnet, dass** während der Durchführung der Echtzeittests das computergestützte Modul der elektronischen Leistungseinrichtung befiehlt, auch für einen zweiten Zeitraum (T2) nach dem ersten Zeitraum dem elektromagnetischen Stellglied elektrische Leistung zuzuführen, wobei die Dauer des zweiten Zeitraums von der Position des beweglichen Kontakts abhängt.

5. Steuervorrichtung nach einem der Ansprüche 3 oder 4, **dadurch gekennzeichnet, dass** während der Durchführung der Echtzeittests die Ladeeinrichtung für zumindest einen dritten Zeitraum (T3) nach den ersten und zweiten Zeiträumen der Energiespeichereinrichtung elektrische Leistung zuführt.

6. Steuervorrichtung nach Anspruch 3, **dadurch gekennzeichnet, dass** das elektromagnetische Stellglied während des ersten Zeitraums seinen Betriebszustand unverändert beibehält.

7. Steuervorrichtung nach Anspruch 4, **dadurch gekennzeichnet, dass** während der ersten und zweiten Zeiträume das elektromagnetische Stellglied mit der Änderung seines Betriebszustands während des ersten Zeitraums beginnt.

8. Steuervorrichtung nach einem der Ansprüche 2 bis 5, **dadurch gekennzeichnet, dass** die elektronische Testeinrichtung eine erste Sensoreinrichtung (13) aufweist, die während des ersten und/oder des zweiten und/oder des dritten Zeitraums Signale, die den Pegel der in der Energiespeichereinrichtung gespeicherten elektrischen Energie anzeigen, an das computergestützte Modul ausgibt.

9. Steuervorrichtung nach einem der Ansprüche 2 bis 5, **dadurch gekennzeichnet, dass** die elektronische Testeinrichtung eine zweite Sensoreinrichtung (14) beinhaltet, die während des ersten und/oder des zweiten Zeitraums Signale, die die Position des beweglichen Kontakts anzeigen, an das computergestützte Modul ausgibt.

10. Steuervorrichtung nach einem oder mehreren der vorangehenden Ansprüche, **dadurch gekennzeichnet, dass** die elektronische Testeinrichtung eine Alarmeinrichtung (16) beinhaltet, die von dem computergestützten Modul aktiviert wird, falls die Echtzeittests des Wirkungsgrads der Betätigungskette das Vorliegen einer Störung anzeigen.

11. Steuervorrichtung nach einem oder mehreren der vorangehenden Ansprüche, **dadurch gekennzeichnet, dass** das elektromagnetische Stellglied (7) aufweist:
- mindestens eine Erregerspule zur Erzeugung eines Magnetflusses; und
- mindestens einen beweglichen Tauchkolben, der wirkmäßig mittels einer kinematischen Kette mit dem beweglichen Kontakt verbunden ist, wobei der bewegliche Tauchkolben durch eine Magnetkraft betätigt wird, die von mindestens einem Teil des Magnetflusses erzeugt wird, verkettet mit dem beweglichen Tauchkolben.

12. Verfahren zur Durchführung von Echtzeittests des Wirkungsgrads der elektromagnetischen Betätigungskette einer Steuervorrichtung nach einem oder mehreren der vorangehenden Ansprüche, **dadurch gekennzeichnet, dass** es zumindest die folgenden Phase umfasst:
- eine erste Phase, in der das elektromagnetische Stellglied über zumindest einen Zeitraum betätigt wird; und
- eine zweite Phase, in der die Menge an elektrischer Energie, die nötig ist, um das elektromagnetische Stellglied zu betätigen, überwacht wird.

13. Verfahren nach Anspruch 12, **dadurch gekennzeichnet, dass** es einen oder mehrere der folgenden Schritte umfasst:
- einen Startschritt, in dem das computergestützte Modul der elektronischen Leistungseinrichtung befiehlt, dem elektromagnetischen Stellglied elektrische Leistung zuzuführen; und
- einen ersten Messschritt, in dem:
- das computergestützte Modul während des ersten Zeitraums von einer ersten Sensoreinrichtung Signale empfängt, die den Pegel der in der Energiespeichereinrichtung gespeicherten elektrischen Energie anzeigen; oder
- das computergestützte Modul während des ersten Zeitraums und eines zweiten Zeitraums Signale von der ersten Sensoreinrichtung, die den Pegel der in der Energiespeichereinrichtung gespeicherten elektrischen Energie anzeigen, und Signale von der zweiten Sensoreinrichtung, die die Position des beweglichen Kontakts anzeigen, empfängt; und
- einen Stoppschritt, in dem das computergestützte Modul der elektronischen Leistungseinrichtung befiehlt, die Zufuhr von elektrischer Leistung zum elektromagnetischen Stellglied zu unterbrechen; und
- einen zweiten Messschritt, in dem das computergestützte Modul während eines dritten Zeitraums nach dem ersten Zeitraum von der ersten Sensoreinrichtung Signale empfängt, die den Pegel der in der Energiespeichereinrichtung gespeicherten elektrischen Energie anzeigen; und
- einen Vergleichsschritt, in dem das computergestützte Modul die Entwicklungsrichtung des Pegels der in der Energiespeichereinrichtung gespeicherten elektrischen Energie während der ersten und dritten Zeiträume mit vorgegebenen Bezugsdaten/- informationen, die in der Steuereinheit gespeichert sind, vergleicht.

14. Verfahren nach Anspruch 13, **dadurch gekennzeichnet, dass** es den folgenden Schritt umfasst:
- einen Alarmschritt, bei dem das computergestützte Modul eine Alarmeinrichtung aktiviert, wenn der Vergleichsschritt anzeigt, dass eine Störung vorliegt.

## Revendications

1. Dispositif de commande (1), pour commander l'opération d'ouverture/fermeture d'un appareillage de commutation, ledit appareillage de commutation comprenant au moins un contact mobile (4) et un contact fixe (3), respectivement accouplés/désaccouplés durant une opération de fermeture/ouverture dudit appareillage de commutation, ledit dispositif de commande comprenant :
- une unité de commande (5) ; et
- une chaîne d'actionnement électromagnétique (6) pour actionner ledit contact mobile, ladite chaîne d'actionnement électromagnétique étant commandée par ladite unité de commande et comprenant au moins un actionneur électromagnétique (7), connecté fonctionnellement audit contact mobile au moyen d'une chaîne cinématique, ladite unité de commande comprenant des moyens d'essai électroniques, pour exécuter des essais en temps réel de l'efficacité opérationnelle de ladite chaîne d'actionnement ;
**caractérisé en ce que** lesdits moyens d'essai électroniques comprennent un module informatisé (11), capable d'exécuter des essais en temps réel de l'efficacité opérationnelle de ladite chaîne d'actionnement, par actionnement dudit actionneur électromagnétique pour au moins une période de temps (T1, T2, T3) et par surveillance de la quantité d'énergie électrique nécessaire pour actionner ledit actionneur électromagnétique pendant ladite période de temps.

2. Dispositif de commande selon la revendication 1, **caractérisé en ce que** ladite chaîne d'actionnement comprend en outre :
- des moyens électronique de puissance (8), connectés électriquement audit actionneur électromagnétique, pour fournir de l'énergie électrique audit actionneur électromagnétique ; et
- des moyens de stockage d'énergie (9), connectés électriquement auxdits moyens électroniques de puissance, pour stocker une quantité d'énergie électrique ; et
- des moyens chargeurs d'énergie (10), connectés électriquement auxdits moyens de stockage d'énergie, pour fournir de l'énergie électrique auxdits moyens de stockage d'énergie.

3. Dispositif de commande selon la revendication 2, **caractérisé en ce que**, durant l'exécution desdits essais en temps réel, ledit module informatisé dicte auxdits moyens électroniques de puissance de fournir de l'énergie électrique audit actionneur électromagnétique, pendant au moins une première période de temps (T1).

4. Dispositif de commande selon la revendication 3, **caractérisé en ce que**, durant l'exécution desdits essais en temps réel, ledit module informatisé dicte auxdits moyens électroniques de puissance de fournir de l'énergie électrique audit actionneur électromagnétique, également pendant une deuxième période de temps (T2), subséquente à ladite première période de temps, l'étendue de ladite deuxième période de temps dépendant de la position dudit contact mobile.

5. Dispositif de commande selon la revendication 3 ou 4, **caractérisé en ce que**, durant l'exécution desdits essais en temps réel, lesdits moyens chargeurs d'énergie fournissent de l'énergie électrique auxdits moyens de stockage d'énergie pendant au moins une troisième période de temps (T3), subséquente auxdites première et/ou deuxième période de temps.

6. Dispositif de commande selon la revendication 3, **caractérisé en ce que**, durant ladite première période de temps, ledit actionneur électromagnétique maintient son état de fonctionnement inchangé.

7. Dispositif de commande selon la revendication 4, **caractérisé en ce que** durant lesdites première et deuxième périodes de temps, ledit actionneur électromagnétique commence à modifier son état opérationnel.

8. Dispositif de commande selon les revendications 2 à 5, **caractérisé en ce que** lesdits moyens d'essai électroniques comprennent des premiers moyens capteurs (13), fournissant audit module informatisé des signaux indicatifs du niveau d'énergie électrique stocké dans lesdits moyens de stockage d'énergie, durant lesdites première et/ou deuxième et/ou troisième périodes de temps.

9. Dispositif de commande selon les revendications 2 à 5, **caractérisé en ce que** lesdits moyens d'essai électroniques comprennent des deuxièmes moyens capteurs (14), fournissant audit module informatisé des signaux indicatifs de la position dudit contact mobile durant lesdites première et/ou deuxième périodes de temps

10. Dispositif de commande selon l'une ou plusieurs des revendications précédentes, **caractérisé en ce que** lesdits moyens d'essai électroniques comprennent des moyens d'alarme (16), activés par ledit module informatisé dans le cas où lesdits essais en temps réel de l'efficacité de la dite chaîne d'actionnement indiquent la présence d'un défaut.

11. Dispositif de commande selon l'une ou plusieurs des revendications précédentes, **caractérisé en ce que** ledit actionneur électromagnétique (7) comprend :
- au moins une bobine d'excitation, pour générer un flux magnétique ; et
- au moins un plongeur mobile, connecté fonctionnellement audit contact mobile au moyen d'une chaîne cinématique, ledit plongeur mobile étant actionné par une force magnétique, générée par au moins une partie dudit flux magnétique, lié audit plongeur mobile.

12. Procédé, pour exécuter des essais en temps réel de l'efficacité opérationnelle de la chaîne d'actionnement électromagnétique d'un dispositif de commande selon l'une ou plusieurs des revendications précédentes, **caractérisé en ce qu'**il comprend au moins les phases suivantes :
- une première phase, dans laquelle ledit actionneur électromagnétique est actionné pendant au moins une période de temps ; et
- une deuxième phase, pendant laquelle la quantité d'énergie électrique, nécessaire au fonctionnement dudit actionneur électromagnétique, est surveillée.

13. Procédé selon la revendication 12, **caractérisé en ce qu'**il comprend une ou plusieurs des étapes suivantes :
- une étape de démarrage, dans laquelle ledit module informatisé dicte aux moyens électroniques de puissance de fournir de l'énergie électrique audit actionneur électromagnétique ; et
- une première étape de mesure, dans laquelle :
- ledit module informatisé reçoit, desdits premiers moyens capteurs, des signaux indicatifs du niveau d'énergie électrique stockée dans les moyens de stockage d'énergie pendant ladite première période de temps ; ou
- ledit module informatisé reçoit, desdits premiers moyens capteurs, des signaux indicatifs du niveau d'énergie électrique stockée dans lesdits moyens de stockage d'énergie et, desdits deuxièmes moyens capteurs, des signaux indicatifs de la position dudit contact mobile, pendant ladite première période de temps et une deuxième période de temps ; et
- une étape d'arrêt, dans laquelle ledit module informatisé dicte auxdits moyens électroniques de puissance de cesser de fournir de l'énergie électrique audit actionneur électromagnétique ; et
- une deuxième étape de mesure, dans laquelle ledit module informatisé reçoit desdits premiers moyens capteurs, des signaux indicatifs du niveau d'énergie électrique stockée dans lesdits moyens de stockage d'énergie pendant une troisième période de temps, subséquente à ladite première période de temps ; et
- une étape de comparaison, dans laquelle ledit module informatisé compare les tendances du niveau d'énergie électrique, stockée dans lesdits moyens de stockage d'énergie pendant lesdites première et troisième période de temps, à des données/information de référence prédéfinie(s), stockée(s) dans ladite unité de commande.

14. Procédé selon la revendication 13, **caractérisé en ce qu'**il comprend les étapes suivantes :
- une étape d'alarme, dans laquelle ledit module informatisé active des moyens d'alarme, si ladite étape de comparaison indique la présence d'un défaut.
